# EUROPEAN PATENT SPECIFICATION

(11) **EP 2 826 892 B1**
(45) Date of publication and mention of the grant of the patent: **28.08.2019**
(21) Application number: 12871080.3
(22) Date of filing: 22.05.2012
(51) Int. Cl.: C30B 29/38, H01L 21/20, C30B 29/40, C30B 33/06, H01L 21/18, H01L 33/00, H01L 33/02, H01L 33/40

(54) **METHOD FOR PREPARING COMPOSITE SUBSTRATE FOR GAN GROWTH**
VERFAHREN ZUR HERSTELLUNG EINES ZUSAMMENGESETZTEN SUBSTRATS FÜR GAN-ZÜCHTUNG
PROCÉDÉ DE PRÉPARATION D'UN SUBSTRAT COMPOSITE POUR PERMETTRE LA CROISSANCE DU NITRURE DE GALLIUM

(30) Priority: 14.03.2012 CN 201210068033
(43) Date of publication of application: 21.01.2015
(73) Proprietor: Sino Nitride Semiconductor Co, Ltd, Guangdong 523500 (CN)
(72) Inventor: SUN, Yongjian, Beijing 100871 (CN); ZHANG, Guoyi, Beijing 100871 (CN); TONG, Yuzhen, Beijing 100871 (CN)
(74) Representative: Bohnenberger, Johannes
(86) International application number: PCT/CN2012/075856
(87) International publication number: WO 2013/135002

(56) References cited:
- EP-A2- 2 006 887
- CN-A- 1 567 602
- CN-A- 101 005 110
- CN-A- 102 244 160
- CN-A- 102 244 160
- US-A1- 2011 097 831
- US-A1- 2011 244 610
- US-B1- 8 129 237
- US-B2- 8 030 176
- YOSHIKAWA A ET AL: "Polarity selection process and polarity manipulation of GaN in MOVPE and RF-MBE growth", THIN SOLID FILMS, ELSEVIER-SEQUOIA S.A. LAUSANNE, CH, vol. 412, no. 1-2, 3 June 2002 (2002-06-03), pages 38-43, XP004369885, ISSN: 0040-6090, DOI: 10.1016/S0040-6090(02)00310-3

## Description

### TECHNICAL FIELD

The present invention relates to the technical field of semiconductor optoelectronic device and Metal-organic Chemical Vapor Deposition (MOCVD), especially a method for preparing a composite used for GaN epitaxial sheet growth.

### BACKGROUND OF THE INVENTION

In recent years, III/V nitride materials, mainly GaN, InGaN, and AIGaN, have received much attention as semiconductor materials. The III/V nitride materials have direct band gaps that can be continuously varied from 1.9 to 6.2 eV, excellent physical and chemical stability, and high saturation electron mobility. They have become the preferred materials for optoelectronic devices such as laser devices and light-emitting diodes.

However, to the present GaN-based semiconductor material device, due to a lack of GaN substrate, the epitaxial films of the GaN-based LED are mainly grown on the substrates such as sapphire substrates, SiC, Si substrate and so on. So far, epitaxial-growth technologies of GaN material series are basically based on highly mismatched hetero-epitaxy technologies. Hetero-epitaxial growth technologies of sapphire substrate is the most widely used and protected. The main problems are that: firstly, the large lattice mismatch and thermal stress between the epitaxially grown GaN and the sapphire substrate can produce high concentration of dislocations of about 10⁹ cm⁻², which seriously degrades the quality of GaN crystal, and reduces illumination efficiency and the lifespan of LED. Secondly, because sapphire is an insulator with an electrical resistivity greater than 10¹¹ Ω cm at room temperature, it is not suitable to be used for forming devices having vertical structures. Sapphire is usually only used to prepare N-type and P-type electrodes on the surface of the epitaxial layer, reducing effective lighting area, increasing the lithography and etching processes during the fabrication of the devices, and reducing the material utilization.Thirdly, sapphire has a poor thermal conductivity of about 0.25 W/cm K at 1000°C, which significantly affects performances of GaN-based devices, especially the large-area and high-power devices in which heat dissipation is required. Fourthly, sapphire has a high hardness and its lattice has a 30 degree angle relative to the lattice of GaN crystal, it is difficult to obtain a cleavage plane of the InGaN epitaxial layer to obtain a cavity surface during the fabrication of GaN-based Laser Diode (LD).

However, to the SiC substrate, it has lattice parameters most close to those of GaN and smaller lattice mismatch, but it also is hetero-epitaxy, also exists misfit dislocations and thermal misfit dislocations. Moreover, SiC is expensive, making it unsuitable for many GaN-based optoelectronic devices (LED). In recently years, Si has also been studied as a substrate for the epitaxial growth of GaN . However, Si has a lattice mismatch to GaN even larger than sapphire/GaN, and Si has cubic crystalline lattice while GaN has a hexagonal crystalline lattice, which makes it difficult to support epitaxial growth of GaN material. The GaN layer grown on Si substrates faces serious problems such as cracking; the growth thickness usually cannot exceed 4 µm.

Therefore, to crystalline epitaxy, either the theory of epitaxial growth, or the development history of the semiconductor epitaxy technology, has proved that, iso-epitaxy is a optimal selection. Recently, preparation technology of GaN mono-crystalline substrate has been developed, the appearance of GaN mono-crystalline substrate, makes GaN epitaxy return to iso-epitaxy, and improves the quality of epitaxially grown GaN crystal. Moreover, the good thermal conductivity of the GaN crystals allows the formation of vertical structure LED on LED epitaxial sheet grown by GaN substrate epitaxy. The properties of the devices are improved under large current injections. However, the high cost of the GaN mono-crystalline substrate severely restricts its usage in LED devices. While a 2 inch wide high power LED epitaxial sheet is typically less than 100 dollars, the price for a 2 inch wide GaN mono-crystalline substrate can reach 2000 dollars at present.

The following may be considered prior art documents:
EP 2 006 887 A2 outlines III-V Nitride semiconductor layer-bonded substrate and semiconductor device. CN 102 244 160 A outlines a method for increasing the efficiency of the LED light preparation method relates to the preparation process of a semiconductor light emitting device. YOSHIKAWA A ET AL outlines polarity selection process and polarity manipulation of GaN in MOVPE and RF-MBE growth. US 8 129 237 B1 outlines a vertical light-emitting diode (VLED) structure fabricated with a SixNy layer responsible for providing increased light extraction out of a roughened n-doped surface of the VLED. US 2011/097831 A1 outlines a method of manufacturing a vertical type light-emitting diode. US 2011/244610 A1 outlines a method for producing a Group III nitride semiconductor light-emitting device whose main surface is a plane that provides an internal electric field of zero, and which exhibits improved light extraction performance.

### SUMMARY OF THE INVENTION

According to the invention, the problem is solved by the subject-matter outlined in the independent claims. Advantageous further developments of the invention are set forth in the dependent claims.

The present invention provides a method for preparing composite substrates for GaN epitaxial sheet growth. In composite substrate, the iso-epitaxy required by GaN epitaxy is provided, crystalline quality is improved, and a vertical structure LED may be directly formed, besides, the production cost is reduced, bringing it into practical application.

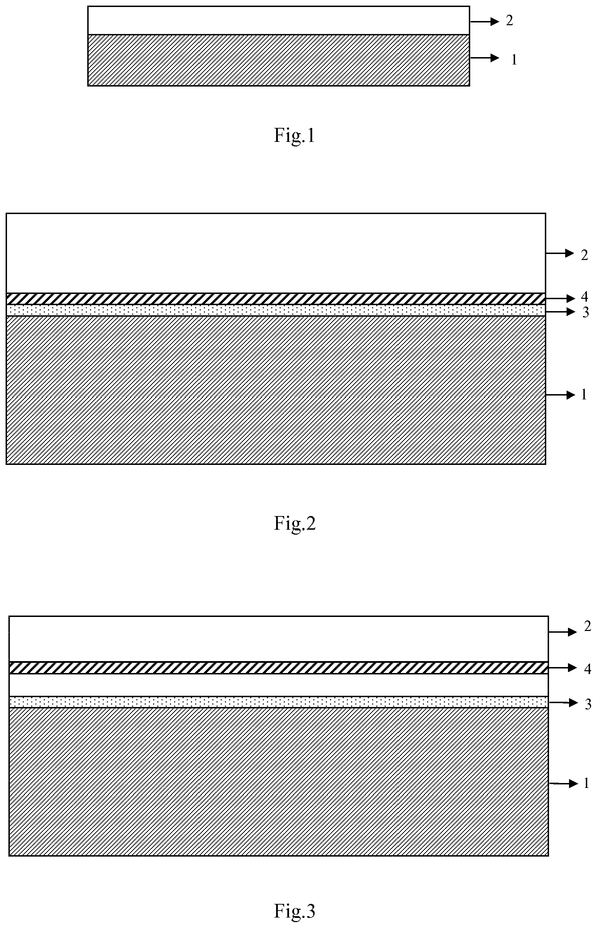

The disclosed composite substrate as shown in Figure 1, includes a thermally and electrically conductive layer 1 and a GaN mono-crystalline layer 2 on the thermally and electrically conductive layer.

The thermally and electrically conductive layer has a thickness in range of 10∼ 3000µm, preferably 50∼400µm. Materials suitable for the thermally and electrically conductive layer are required to have several characteristics: (1) a melting point greater than 1000°C, or nearly in solid state under 1000°C; and (2) high thermal and high electrical conductivities.

Based on the above requirements, materials suitable for the thermally and electrically conductive layer can choose from metal elements or alloys or quasi-alloys, such as W, Ni, Mo, Pd, Au, Cr and so on, or alloys of any two or more kinds of the above metals, or alloys of one or more above metals with Cu, such as WCu alloy, MoCu alloy and NiCu alloy and so on. Besides metals, other materials suitable for the thermally and electrically conductive layer can also be Si crystalline, SiC crystalline or AlSi crystalline and so on.

The GaN layer on the thermally and electrically conductive layer has a thickness in a range of 0.1∼100µm, preferably 1∼50µm. The GaN crystal is in the form of a mono crystal.

The thermally and electrically conductive layer can be bonded with the GaN mono-crystalline layer through rigid bonding or flexible bonding. If the bonding is a rigid van der Waals force bonding, the thermal expansion coefficient of the thermally and electrically
conductive layer should be close to the thermal expansion coefficient of the GaN mono-crystalline layer, and the "close" here means the difference of the coefficient of thermal expansion is within 10%, and there's no medium between the thermally and electrically conductive materials. And the thermally and electrically conductive layer can also be bonded with GaN layer through a flexible medium. If bonded through a flexible medium, the medium is required to have a melting point greater than 1000°C, and certain ductility, to relax stress, preferably Au-Au bonds with a thickness ranged 0.5∼5µm, or bonds between W, Pd or Ni and other high-temperature metals. The metal medium bonding layer with the said thickness, can relax the thermal mismatch stress produced by different coefficient of thermal expansions between the GaN layer and the thermally and electrically conductive layer, therefore, while bonded with the flexible medium, the thermal expansion coefficient of the thermally and electrically conductive layer is not required to be close to that of GaN.

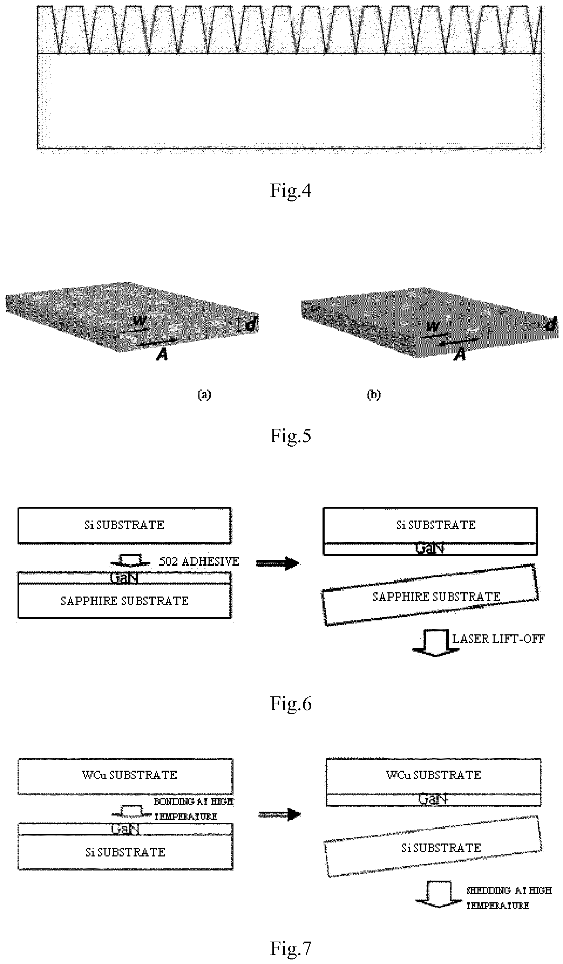

Furthermore, the composite substrate of the present invention can include a reflective layer, located inside, in the lower portion, or a lower surface of the GaN mono-crystalline layer which is the interface of the GaN mono-crystalline layer bonded with the thermally and electrically conductive layer. The reflective layer can be sandwiched at the bonding layer between the thermally and electrically conductive layer and the GaN layer close to GaN layer (that is between the bonding layer and the GaN layer), referring to Figure 2, and it could also be located inside or in the lower portion of the GaN layer, as shown in Figure 3. If the reflective layer is sandwiched at the bonding layer that is close to the GaN layer, the reflective layer can be metallic reflective layer, such as Pd, Cr and so on. If the reflective layer is located inside or in the lower portion of the GaN layer, the reflective layer can be in a periodic or quasi-periodic structure, with grating structures or photonic lattice structures, as shown in Figure 4.

The said grating structures are micron-scale periodic structures, the said photonic lattice structures are nano-scale periodic structures which can be periodic protrusions or recesses. The protrusions and the recesses can have conical shapes, truncated cone shapes, cylindrical shapes, triangular pyramidal shapes, or other shapes. As shown in Figure 5, wherein (a) shows triangular pyramidal recesses distributed periodically, (b) shows cylindrical recesses distributed periodically. These micron-scale or nano-scale periodic structures could be 10nm∼50µm, preferably 200nm∼10µm. In Figure 5, w and d respectively represent the largest width and depth of the recesses, A represents period of structure, wherein A> w.

The micron-scale or nano-scale periodic structures in the reflective layers are usually made of heat-resistant (melting point greater than 1000° C) materials with a refractive index different from that of the GaN, for example, forming periodic structures by materials such as SiO₂, SiN that can grow in a crystalline phase, or coated on or embedded in the GaN mono-crystalline layer. These materials have refractive index different from that of GaN, and generate effective total internal reflections, and the average refractive index at the interface is efficiently increased by the periodic structures.

In some instances, the periodic structures located at the lower portion of the GaN layer are not made of materials different from GaN, but are just periodic patterns formed at the lower portion of the GaN layer, such periodic patterns can also act as reflective layers.

The reflective layer plays a very important role on the GaN-based devices epitaxially grown on the composite substrate Usually, in the light emitting devices epitaxially grown on the substrates, the light from active layer can be emitted in a 360 degree angular range, if there's no design of reflective layer, 40% of the light emitted to the thermally and electrically conductive layer direction from luminescent materials will be absorbed by the substrates and won't be emitted, therefore, the incorporation of the reflective layers to the disclosed composite substrate can thus increase light emission efficiency more than 30%..

The composite substrate can be directly used for the epitaxial-growth of GaN epitaxial sheets, and thus the preparation of a vertical structure LED device. The disclosed composite substrate has the one or more following additional advantages compared with conventional technologies:
Firstly, compared with the growth of sapphire substrate in the prior art. Nowadays, sapphire substrate is a substrate that is the most commonly used for growth of GaN epitaxial sheets, because the sapphire substrate has non electro-conductivity and non thermal-conductivity, it's difficult or impossible to grow a vertical structure LED device by the GaN grown on the sapphire substrate, and the planar structure LEDs grown on sapphire substrates the most commonly do not dissipate heat well and are not suitable for high power devices. Additionally, sapphire substrate has a different lattice from that of GaN, which limits the quality of GaN crystals, making it unable to prepare high quality GaN epitaxial sheets.
   Compared with the sapphire substrate, the composite has very obvious advantages. On one hand, the composite substrate has a GaN layer that enables iso-epitaxial growth of GaN epitaxial sheets on the composite substrate, with improved crystalline quality of growing GaN epitaxial sheets, and thus increased quantum efficiency. On the other hand, there is a thermally and electrically conductive layer in the composite substrate, which allows a vertical structure LED device to be directly prepared by GaN epitaxial sheets grown on the composite substrate according to traditional chip technology, without the limit of the non electro-conductivity and non thermal-conductivity of the substrate, which greatly increases device efficiency.
Secondly, compared to the growth of Si substrate and SiC substrate in the prior art. Although a vertical structure LED may be directly prepared by GaN epitaxial sheets grown on this two kinds of substrates, because of their electro-conductivity and thermal-conductivity, both of them are hetero-epitaxy, which are not good for improving the crystalline quality of GaN. Especially for the Si substrate, AIGaN layers need to be inserted between epitaxy grown GaN crystal on it to relax stress, and the GaN crystal can hardly grow thicker than 3-4 µm on Silicon substrate. Although the lattice constant of a SiC substrate is close to that of a GaN crystal, it is difficult to prepare SiC crystals, and costs are high, which makes it's difficult to be widely applied in GaN-based high power LED devices. Compared with the two kinds of substrates, the main advantages of the composite substrate of the present invention are that, the composite substrate enables iso-epitaxial growth, which can greatly improve the crystalline quality of GaN epitaxial sheets, and makes it suitable for a wide range of applications.
Lastly, compared with GaN mono-crystalline substrate, GaN mono-crystalline substrate which is iso-epitaxial substrate and the composite substrate provide iso-epitaxy growth, and the crystalline quality are greatly improved by employing the epitaxial growth of the two kinds of substrates. However, compared with the high cost of the GaN mono-crystalline substrate, the composite substrate employs thermally and electrically conductive materials of raw materials cost lower, and GaN layer whose thickness is only one in four hundred to one quarter of the GaN mono-crystalline substrates, the price of which is far lower than GaN mono-crystalline substrates, so there is a more wider application aspect.

For preparing the said composite substrate used for GaN growth, two kinds of methods are provided in the present invention, respectively for preparing a composite substrate of face-up gallium polarity and a composite substrate of face-up nitrogen polarity.

The first method for preparing a composite substrate of face-up gallium polarity, comprises the steps of:
1a) growing a GaN mono-crystalline epitaxial layer on a sapphire substrate;
1b) bonding the GaN epitaxial sheet grown on a sapphire substrate onto a temporary substrate with an epoxy-type instant adhesive, then lifting off the sapphire substrate by a laser lift-off method;
1c) bonding the GaN epitaxial sheet on the temporary substrate with a thermally and electrically conductive substrate with a melting point greater than 1000°C, the epoxy-type instant adhesive is carbonized at high temperature, shedding the temporary substrate, and so obtaining the composite substrate in which the GaN epitaxial sheet of face-up gallium polarity is bonded to the thermally and electrically conductive substrate, after surface cleaning.

In the said step 1a), the method for growing GaN can use the MOCVD method or HPVE method well-known in the art, or use the MOCVD method combined with the HPVE method. Usually first using the MOCVD method, then using the HPVE method (hydride vapor phase epitaxy) for growing GaN mono-crystalline .

The said patterned sapphire substrate can be a flat or patterned sapphire substrate. The patterned sapphire substrate is designed according to the structure of the reflective layer in the composite substrate, obtained by preparing micron-scale or nano-scale periodic structural patterns on the surface of the sapphire substrate by lithography lift-off method well-known in the art. To the GaN mono-crystalline layer grown by the patterned sapphire substrate and transferred onto the temporary substrate, the patterns of the sapphire substrate have been transferred onto the GaN layer successfully while being lifted off, which can be used as reflective layer. But to the GaN mono-crystalline layer grown by a flat sapphire substrate, the reflective layer can be prepared by one of the following two methods:
I. After the GaN mono-crystalline layer being transferred from the sapphire substrate onto the temporary substrate in the step 1b), deposit a metal reflective layer (with a thickness of less than 1µm) on the surface of the GaN mono-crystalline by the deposition technique well-known in the art, and then conduct step 1c). In the composite substrate of face-up gallium polarity prepared finally, the reflective layer is located on the lower surface of the GaN mono-crystalline layer.
II. In the process of GaN epitaxial-growth in the step 1a), first growing a layer of GaN, then growing a layer of reflective layer materials, patterning the layer of reflective layer materials with lithography and dry etched well-known in the art into micron-scale or nano-scale periodic structures(i.e the reflective layer structure), and the GaN surface between the space of these structures is exposed at the same time, and then growing GaN mono-crystalline continuously to the required thickness, and then conducting the step 1c). In the composite substrate of face-up gallium polarity prepared finally, the reflective layer is located inside of the GaN mono-crystalline layer.

In the said method II, the reflective layer materials required to have a refractive index different from that of GaN, and a melting point greater than 1000°C, can be grown in a crystalline phase, or be coated, such as SiO₂ and SiN. SiO₂ layer and SiN layer can be grown by PECVD method(Plasma Enhanced Chemical Vapor Deposition), with a thickness of 0.2µm∼2µm.

In the said step 1b), the said epoxy-type instant adhesive can be 502 adhesive for example, the said temporary substrate can be metal temporary substrate or Si mono-crystalline temporary substrate.

In the said step 1c), the bonding method can use rigid or flexible medium to bond. The rigid bonding is that, without depositing any bonding metal, Van der Waals bonding the GaN epitaxial sheet on the temporary substrate with a thermally and electrically conductive substrate directly, by van der Waals force, at 500∼900°C, under a pressure of 3 tons per square inch to 10 tons per square inch. As mentioned above, the rigid bonding requires the coefficient of thermal expansion difference between the materials of the thermally and electrically conductive layer and GaN is within 10%, such as Si mono-crystalline substrate, SiC mono-crystalline substrate and AISi crystalline substrate.

The flexible medium bonding is that, depositing bonding metal on the surface to be bonded, and then bonding the GaN epitaxial sheet on the temporary substrate with a thermally and electrically conductive substrate, at 200∼900°C, under a pressure of 1 tons per square inch to 5 tons per square inch. The thickness of the bonding layer bonded by flexible medium preferably is 0.5∼5µm, the bonding metal can be Au, W, Pd, Ni and so on.

The second method for preparing a composite substrate of face-up nitrogen polarity, comprises the steps of:
2a) growing a GaN mono-crystalline epitaxial layer on a sapphire substrate;
2b) bonding the epitaxial sheet grown on a sapphire substrate with the thermally and electrically conductive layer with a melting point greater than 1000°C;
2c) lifting off the sapphire substrate by laser lift-off method, obtaining a composite substrate of face-up nitrogen polarity with the GaN epitaxial sheet bonded with the thermally and electrically conductive layer.

In the said step 2a), the method for growing GaN can use the MOCVD method or HPVE method well-known in the art, or use the MOCVD method combined with the HPVE method. Usually first using the MOCVD method, then using the HPVE method (hydride vapor phase epitaxy) for growing GaN mono-crystalline .

The GaN mono-crystalline epitaxial layer is grown on the plate sapphire substrate, to the composite substrate with a reflective layer designed, before conducting the step 2b), one of the following two methods can be used for preparing the reflective layer:
A. Deposit a metal reflective layer (with a thickness of less than 1µm) on the surface of the GaN mono-crystalline prepared by the step 2a) by the deposition technique well-known in the art, and then conduct step 2b). In the composite substrate of face-up nitrogen polarity prepared finally, the reflective layer is located on the lower surface of the GaN mono-crystalline layer.
B. In the process of GaN epitaxial-growth in the step 2a), first growing a layer of GaN , then growing a layer of reflective layer materials, patterning the layer of reflective layer materials with lithography and dry etched well-known in the art into micron-scale or nano-scale periodic structures(i.e the reflective layer structure), and the GaN surface between the space of these structures is exposed at the same time, and then growing GaN mono-crystalline continuously to the required thickness, and then conducting the step 2b). In the composite substrate of face-up nitrogen polarity prepared finally, the reflective layer is located inside the GaN mono-crystalline layer. In the said method B, the reflective layer materials are required to have a refractive
index different from that of GaN, a melting point greater than 1000°C, can be grown in a crystalline phase, or be coated, such as SiO₂ and SiN. SiO₂ layer and SiN layer can be grown by PECVD method(Plasma Enhanced Chemical Vapor Deposition), with a thickness of 0.2µm∼2µm.

In the said step 2b), the bonding method can use rigid or flexible medium to bond. The rigid bonding is that, without depositing any bonding metal, Van der Waals bonding the GaN epitaxial sheet on the sapphire substrate with a thermally and electrically conductive substrate directly, by van der Waals force, at 500∼900°C, under a pressure of 3 tons per square inch to 10 tons per square inch. As mentioned above, the rigid bonding requires the coefficient of thermal expansion difference between the materials of the thermally and electrically conductive layer and GaN is within 10%, such as Si mono-crystalline substrate, SiC mono-crystalline substrate and AlSi crystalline substrate.

The flexible medium bonding is that, depositing bonding metals on the surface to be bonded, and then bonding the GaN epitaxial sheet on the temporary substrate with a thermally and electrically conductive substrate, at 200∼900°C, under a pressure of 1 tons per square inch to 5 tons per square inch. The thickness of the bonding layer bonded by flexible medium preferably is 0.5∼5µm, the bonding metals can be Au, W, Pd, Ni and so on.

In a word, in the present invention, new types of composite substrate are prepared by laser lift-off technique, bonding technique, micromachining technique and epitaxy technique, iso-epitaxy required by GaN epitaxy is provided, crystal quality is improved, and a vertical structure LED may be directly prepared. Further, a thin-layer GaN mono-crystalline is used, so the cost is greatly reduced, making it have great advantage in the GaN substrate in the prior art.

### Description of the drawings

Figure 1 is a basic schematic diagram of the composite substrate used for GaN growth of the present invention.
Figure 2 is a schematic diagram of the composite substrate in which a reflective layer is located at the side close to the GaN layer of the bonding layer of the composite substrate.
Figure 3 is a schematic diagram of the composite substrate in which a reflective layer is located inside of the GaN layer of the composite substrate.
Figure 4 is a schematic diagram of a periodic grating or a periodic photonic lattice structure of the reflective layer.
Figure 5 is a schematic diagram of the reflective layer having triangular pyramidal recess (a) or cylindrical recess (b) shaped periodic structures.
Figure 6 is a schematic diagram showing the steps of bonding the Si substrate with 502 adhesive and lifting off the sapphire substrate by laser in the second step as described in Embodiment 1.
Figure 7 is a schematic diagram showing the steps of bonding at high temperature and shedding Si substrate at high temperature in the third step as described in Embodiment 1.

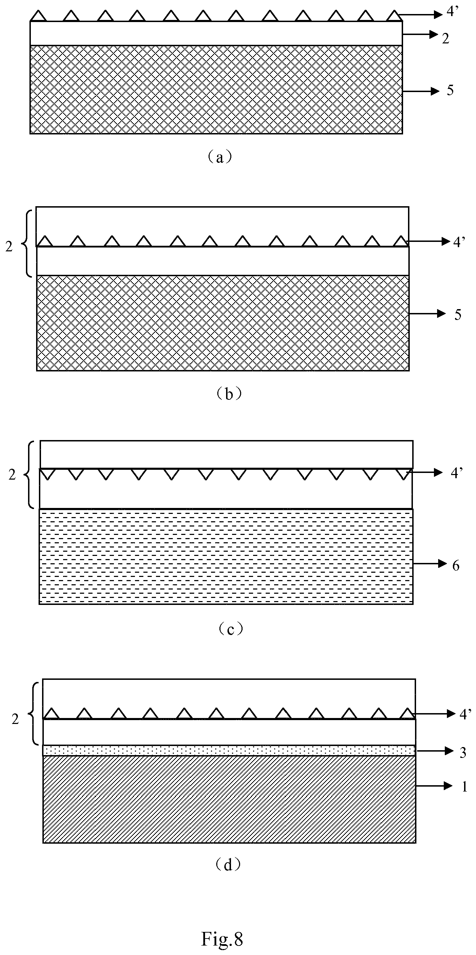

Figure 8 is a flowchart showing the preparation of GaN/WCu composite substrate in which there's a reflective layer in the GaN layer as described in Embodiment 2, wherein: (a) is a schematic diagram showing the preparation of SiO₂ periodic reflective layer on the GaN surface of 4µm GaN/sapphire substrate in the second step; (b) is a schematic diagram showing growing GaN continuously by HVPE Technology until the thickness of GaN reaches to 10µm after the reflective layer is prepared in the third step; (c) is a schematic diagram showing the GaN layer with a reflective layer located on the Si substrate obtained after manufacture in the fourth step; (d) is a schematic diagram showing GaN/WCu composite substrate obtained finally.
Figure 9 is a flowchart showing the preparation of GaN/MoCu composite substrate in which there's a metal reflective layer as described in Embodiment 4, wherein: (a) is a schematic diagram showing the structure obtained by depositing a Pd metal reflective layer on the GaN mono-crystalline layer bonded on the Si substrate in the third step; (b) is a schematic diagram showing obtaining GaN/MoCu composite substrate with a Pd metal reflective layer by Ni-Ni bonds.

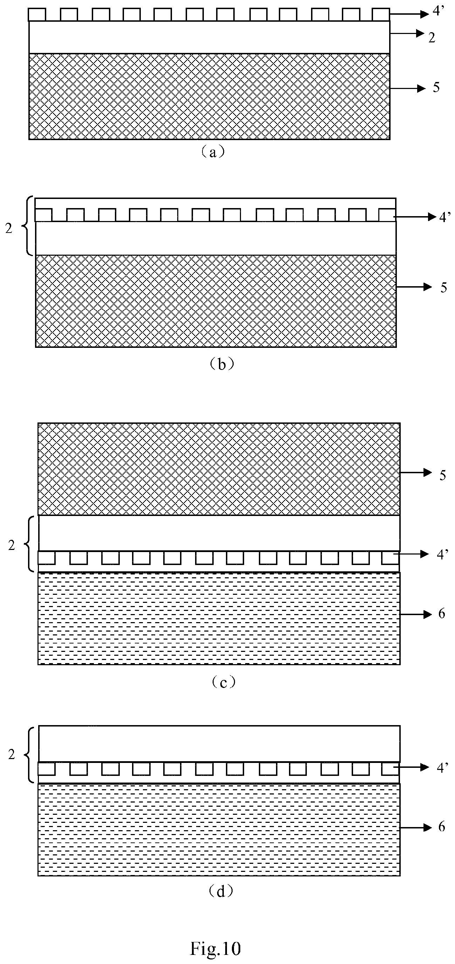

Figure 10 is a flowchart showing the preparation of composite substrate in which the GaN layer is bonded with Si substrate by a van der Waals force as described in Embodiment 5, wherein: (a) is a schematic diagram showing the preparation of SiO₂ cylindrical periodic structures on the GaN surface of GaN/sapphire substrate in the third step; (b) is a schematic diagram showing growing GaN continuously by HVPE technology until the thickness of GaN reaches to 50 µm after the reflective layer is prepared in the fourth step; (c) is a schematic diagram showing the formation of sapphire substrate/GaN/Si structure by a van der Waals force in the fifth step; (d) is a schematic diagram showing the GaN/Si composite substrate obtained by laser lift-off .

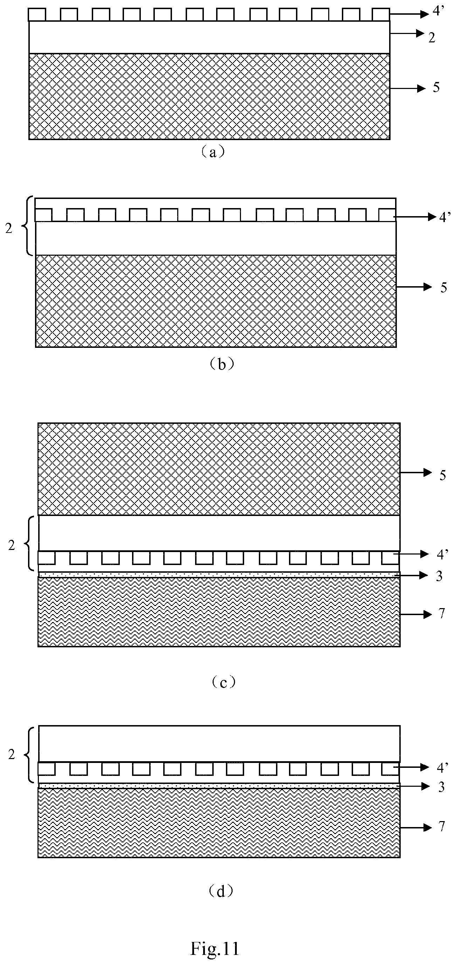

Figure 11 is a flowchart showing the preparation of composite substrate in which the GaN layer and a AISi substrate is bonded with Au-Au bonds as described in Embodiment 7, wherein: (a) is a schematic diagram showing the preparation of SiO₂ cylindrical periodic structures on the GaN surface of GaN/sapphire substrate in the third step; (b) is a schematic diagram of growing GaN continuously by HVPE Technology until the thickness of GaN reaches to 10µm after the reflective layer is prepared in the fourth step; (c) is a schematic diagram showing the formation of sapphire substrate/GaN/AISi structure by Au-Au bonds in the fifth step; (d) is a schematic diagram showing the GaN/AISi composite substrate obtained by laser lift-off in the sixth step.

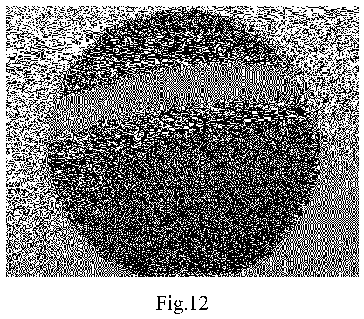

Figure 12 is a photograph of the composite substrate prepared by the present invention in which the GaN mono-crystalline layer is bonded with a metal substrate.

In the figure:
1-the thermally and electrically conductive layer, 2-the GaN layer, 3-the bonding layer, 4-the reflective layer, 4'-the graphical structures of reflective layer , 5-the sapphire substrate, 6-the Si substrate, 7-the AlSi mono-crystalline substrate.

### Detailed description of the invention

Next, with reference to the drawings, the present invention will be illustrated in detail through the embodiments.

### Embodiment 1: A metal composite substrate without reflective layer comprising a WCu metal substrate and a GaN layer bonded with Au-Au bonds

In the first steps, first a 4 µm thick GaN mono crystal epitaxial sheet is grown on a 2 inch 430 µm thick panel sapphire substrate using Metal-organic Chemical Vapor Deposition (MOCVD) well-known in the art, and then a GaN crystal is grown to a crystal thickness of 10 µm using hydride vapor phase epitaxy (HVPE) technique well-known in the art.

In the second steps, the GaN surface of the said GaN mono-crystalline that has been grown is bonded to a 2 inch 400 µm thick Si mono-crystalline substrate using 502 instant adhesive, using the Si substrate as a transfer and support substrate, and then the sapphire substrate is lifted off using laser lift-off technology well-known in the art, leaving a GaN mono-crystalline bonded on the Si substrate, as shown in Figure 6.

In the third steps, a 1µm Au layer is deposited simultaneously on the GaN surface of GaN mono-crystalline on the Si substrate and the surface of WCu alloy substrate, and
then they are bonded together at 300°C, under a pressure of 5 tons, for 15 minutes. After bonding, the 502 instant adhesive is carbonized at high temperature, which allows Si substrate to separate from GaN/WCu composite substrate automatically.

At last, a GaN/WCu composite substrate is obtained after surface cleaning, which includes a 150 µm thick WCu alloy metal substrate with a W:Cu mass ratio of 15:85. The WCu alloy metal substrate and a layer of 10 µm thick GaN mono-crystalline are bonded with Au-Au bonds,wherein the bonding layer is 2µm in thickness.

### Embodiment 2: A metal composite substrate comprising a WCu metal substrate and a GaN layer bonded with Au-Au bonds

In the first steps, a 4µm thick GaN mono-crystalline epitaxial sheet is grown on a 2 inch 430 µm thick panel sapphire substrate using MOCVD technology well-known in the art.

In the second steps, a 1 µm layer of SiO₂ thin film is grown on the surface of the said GaN mono-crystalline that has been grown using plasma enhanced chemical vapor deposition (PECVD) technology, the SiO₂ thin layer is then patterned with lithography and dry etched well-known in the art into periodic conical structures spaced by a period of about 3 µm, with a base diameter of about 2.5µm and a height of about 1 µm, as shown in Figure 8 (a). The GaN surface is exposed in the space between the conical patterns. The periodic structures can be used as a reflective layer.

In the third steps, a GaN crystal layer is continuously grown on the surface of the said GaN mono-crystalline that has been prepared with a reflective layer using HVPE technology well-known in the art, until the thickness of GaN mono-crystalline reaches to 10µm, as shown in figure 8 (b).

In the fourth steps, the GaN surface of the said GaN mono-crystalline that has been grown is bonded with a 2 inch 400 µm thick Si mono-crystalline substrate by 502 instant adhesive, using Si substrate as a transfer and support substrate, and the sapphire substrate is then lifted off by laser lift-off technology well-known in the art, leaving GaN mono-crystalline bonded on the Si substrate, as shown in figure 8 (c).

In the fifth steps, a 1µm Au layer is deposited simultaneously on the GaN surface of GaN mono-crystalline on the Si substrate and the surface of WCu alloy substrate, and then they are bonded together at 300°C, under a pressure of 5 tons, for 15 minutes. After bonding, the 502 instant adhesive is carbonized at high temperature, which allows Si substrate to separate from GaN/WCu composite substrate automatically (refer to figure 7 ).

At last, a composite substrate as shown in figure 8 (d) is obtained after surface cleaning, which includes a 150 µm thick WCu alloy metal substrate 1 with a W:Cu mass ratio of 15:85. The WCu alloy metal substrate and a layer of 10 µm thick GaN mono-crystalline layer 2 are bonded with Au-Au bonds, wherein the bonding layer 3 is 2µm in thickness. A layer of graphical structures of reflective layer 4' is embedded in the GaN layer 2 and is at 4 µm distance from the bonding layer. The patterns are conical SiO₂ graphical layer structures spaced at a 3 µm period, with a height of 1 µm and a bottom diameter of 2.5µm.

### Embodiment 3: A metal composite substrate comprising a MoCu metal substrate and a GaN layer bonded with Au-Au bonds

In the first steps, a 4 µm thick GaN mono-crystalline epitaxial sheet is grown on a 2 inch 430 µm thick panel sapphire substrate using MOCVD technology well-known in the art.

In the second steps, a layer of 1 µm thick SiO₂ thin film is grown on the surface of the said GaN mono-crystalline that has been grown using PECVD technology, and the SiO₂ thin layer is then patterned with lithography and dry etched well-known in the art into periodic conical structures spaced by a period of 3µm, with a base diameter of 2.5µm , a height of 1µm, as shown in figure 8 (a). The GaN surface is exposed in the space between the conical patterns. The periodic structures can be used as a reflective layer.

In the third steps, a GaN crystal layer is continuously grown on the surface of the said GaN mono-crystalline with a reflective layer prepared using HVPE technology well-known in the art, until the thickness of GaN mono-crystalline reaches to 10µm, as shown in figure 8 (b) .

In the fourth steps, the GaN surface of the said GaN mono-crystalline that has been grown and a 2 inch 400 µm thick Si mono-crystalline substrate are bonded with 502 instant adhesive, using the Si substrate as a transfer and support substrate, and the sapphire substrate is then lifted off by laser lift-off technology well-known in the art, leaving GaN mono-crystalline bonded on the Si substrate, as shown in figure 8 (c) .

In the fifth steps, a 1 µm Au layer is deposited simultaneously on the GaN surface of GaN mono-crystalline on the Si substrate and the surface of MoCu alloy substrate, and then they are bonded together at 300°C, under a pressure of 5 tons, for 15 minutes. After bonding, the 502 instant adhesive is carbonized at high temperature, which allows Si substrate to separate from GaN/MoCu composite substrate automatically.

At last, a GaN/MoCu composite substrate is obtainedafter surface cleaning, which includes a layer of 150 µm thick MoCu alloy metal substrate with a Mo:Cu mass ratio of 20:80. The MoCu alloy metal substrate and a layer of 10 µm thick GaN mono-crystalline are bonded with Au-Au bonds, wherein the bonding layer Au is 2µm in thickness. A layer of graphical structures of reflective layer is embedded in the GaN layer and is at 4 µm distance from the bonding layer. The patterns are conical SiO₂ graphical layer structures spaced at a 3 µm period, with a base diameter of about 2.5µm and a height about 1 µm.

### Embodiment 4: A metal composite substrate comprising a MoCu metal substrate and a GaN layer bonded with Ni-Ni bonds

In the first steps, a 4 µm thick GaN mono-crystalline epitaxial sheet is grown on a 2 inch 430 µm thick panel sapphire substrate using MOCVD technology well-known in the art.

In the second steps, the GaN surface of the said GaN mono-crystalline that has been grown and a 2 inch 400 µm thick Si mono-crystalline substrate are bonded with 502 instant adhesive, using the Si substrate as a transfer and support substrate, and the sapphire substrate is then lifted off by laser lift-off technology well-known in the art, leaving GaN mono-crystalline bonded on the Si substrate.

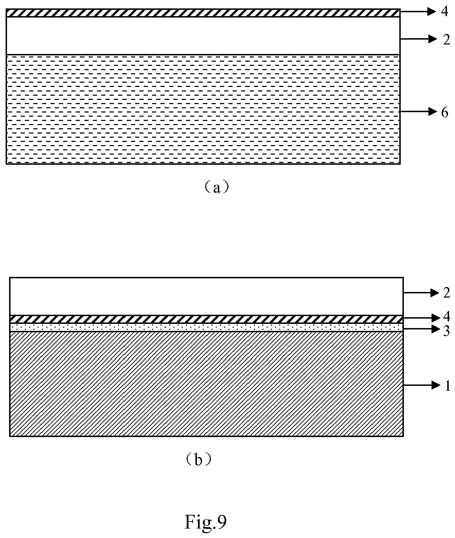

In the third steps, a reflective layer 4 is formed by depositing a 200 nm Pd metal layer on the surface of the GaN mono-crystalline layer 2 on the Si substrate 6, as shown in Figure 9 (a) .

In the fourth steps, a 2µm Ni is deposited simultaneously on the reflective layer of GaN mono-crystalline on the Si substrate that has deposited the reflective layer and the surface of MoCu alloy substrate, and then they are bonded together at 800°C, under a pressure of 15 tons, for 15 minutes. After bonding, the 502 instant adhesive is carbonized at high temperature, which allows Si substrate to separate from GaN/MoCu composite substrate automatically.

At last, a composite substrate as shown in 9 (b) is obtained after surface cleaning, which includes a layer of 150 µm thick MoCu alloy metal substrate 1 with a Mo:Cu mass ratio of 20:80. The MoCu alloy metal substrate 1 and a layer of 4 µm thick GaN mono-crystalline 2are bonded with Ni-Ni bonds, wherein the bonding layer 3 is 4µm in thickness. A layer of Pd metal reflective layer 4 is embedded in the GaN layer 2 and is at 4 µm distance from the bonding layer 3.

### Embodiment 5: A composite substrate comprising a Si substrate and a GaN layer bonded by van der Waals force

In the first steps, a 4 µm thick GaN mono-crystalline epitaxial sheet grown on a 2 inch 430 µm thick panel sapphire substrate using MOCVD technology well-known in the art.

In the second steps, the said GaN mono-crystalline is continuously grown using HVPE technology well-known in the art, until the thickness of GaN mono-crystalline reaches to 46µm.

In the third steps, a layer of 1 µm thick SiO₂ thin film is grown on the surface of the said GaN mono-crystalline that has been grown by PECVD technology, and the SiO₂ thin layer is then patterned with lithography and dry etched well-known in the art into periodic cylindrical structures spaced by a period of about 3 µm, with a base diameter of about 2 µm and a height about 1 µm, as shown in figure 10 (a) . The surface of the GaN crystal layer is exposed in the space between the cylindrical structures. The periodic structure can be used as a reflective layer.

In the fourth steps, the said GaN mono-crystalline that has prepared a reflective layer is continuously grown using HVPE technology well-known in the art, until the thickness of GaN mono-crystalline reaches to 50µm, as shown in figure 10 (b) .

In the fifth steps, the said GaN mono-crystalline prepared with a reflective layer and a 400 µm thick Si sheet are bonded by van der Waals force, at 900°C, under a pressure of 20 tons, for 30 minutes, forming a structure sample like sapphire/GaN/Si, as shown in 10 (c) .

In the sixth steps, the sapphire substrate is then lifted off by laser lift-off technology well-known in the art, leaving the composite substrate with GaN/Si bonded, as shown in figure 10 (d) .

At last, a composite substrate as shown in 10 (d) is obtained after surface cleaning, which includes a layer of 400 µm thick Si mono-crystalline substrate 6, bonded with a layer of 50 µm thick GaN mono-crystalline 2 through a van der Waals force. A layer of graphical structures of reflective layer 4' is embedded in the GaN layer 2 and is at a 4 µm distance from the bonding layer. The graphical structures of reflective layer 4' are cylindrical SiO₂ structures spaced at a 3 µm period with a base diameter of about 2 µm and a height about 1 µm.

### Embodiment 6: A metal composite substrate comprising a SiC substrate and a GaN layer bonded with Pd-Pd bonds

In the first steps, a 4 µm thick GaN mono-crystalline epitaxial sheet is grown on a 2 inch 430 µm thick panel sapphire substrate using MOCVD technology well-known in the art.

In the second steps, a layer of 1 µm thick SiO₂ thin film is grown on the surface of the said GaN mono-crystalline that has been grown using PECVD technology, and the SiO₂ thin layer is then patterned with lithography and dry etched well-known in the art into periodic conical structures spaced by a period of about 3 µm, with a bottom diameter of 2.5 µm, a height of 1 µm, as shown in figure 8 (a) . The GaN surface is exposed in the space between the conical structures . The periodic structure can be used as a reflective layer.

In the third steps, the above GaN mono-crystalline that has prepared a reflective layer is continuously grown by HVPE technology well-known in the art, until the thickness of GaN mono-crystalline reaches to 10µm, as shown in figure 8 (b) .

In the fourth steps, the GaN surface of the above GaN mono-crystalline grown and a 2 inch 400 µm thick Si mono-crystalline substrate are bonded by 502 instant adhesive, using Si substrate as a transfer and support substrate. And the sapphire substrate is then lifted off by laser lift-off technology well-known in the art, leaving GaN mono-crystalline bonded on the Si substrate, as shown in figure 8 (c) .

In the fifth steps, a 1 µm Pd layer is deposited simultaneously on the GaN surface of the GaN mono-crystalline on the Si substrate and the surface of 200 µm thick SiC substrate . And then they are bonded together at 800°C, under a pressure of 8 tons, for 15 minutes. After bonding, the 502 instant adhesive is carbonized at high temperature, which allows Si substrate to separate from GaN/SiC composite substrate automatically.

At last, a composite substrate as shown in figure 8 (d) is obtained after surface cleaning, which only replaces the WCu alloy metal substrate in Embodiment 2 with a layer of 200 µm thick SiC mono-crystalline substrate which is bonded with a layer of 10 µm thick GaN mono-crystalline by Pd-Pd bonds, wherein the bonding layer Pd is 2µm in thickness. A layer of graphical structures of reflective layer is embedded in the GaN layer and is at a 4 µm distance from the bonding layer. The graphical structures of reflective layer are cylindrical SiO₂ graphical layer structures spaced at a 3 µm period with a base diameter of about 2.5 µm and a height about 1 µm.

### Embodiment 7: A composite substrate comprising a AISi substrate and a GaN layer bonded with Au-Au bonds

In the first steps, a 6µm-thick GaN mono-crystalline epitaxial sheet is grown on a 2 inch 430 µm thick panel sapphire substrate using MOCVD technology well-known in the art.

In the third steps, a layer of 1µm thick SiO₂ thin film is continuously grown on the surface of the above GaN mono-crystalline that has been grown by PECVD technology, and the SiO₂ thin layer is then patterned with lithography and dry etched well-known in the art into periodic conical structures spaced by a period of 3µm, with a bottom diameter of 2 µm, a height of 1µm, as shown in figure 11 (a) .The surface of GaN is exposed in the space between the conical structures . The periodic structure can be used as a reflective layer.

In the fourth steps, the above GaN mono-crystalline line that has prepared a reflective layer is continuously grown by HVPE technology well-known in the art, until the thickness of GaN mono-crystalline line reaches to 10µm, as shown in figure 11 (b) .

In the fifth steps, a 1µm Au layer is deposited simultaneously on the GaN surface of the sapphire substrate/GaN mono-crystalline line and the surface of 200µm thick AISi substrate . And then they are bonded together at 300°C, under a pressure of 5 tons, for 15 minutes, as shown in figure 11 (c) .

In the sixth steps, the sapphire substrate is lifted off by laser lift-off technology well-known in the art, leaving a composite substrate structure with GaN/AISi bonded, as shown in figure 11 (d) .

At last, a composite substrate as shown in figure 11 (d) is obtained after surface cleaning, which includes a layer of 200 µm thick AISi mono-crystalline substrate 7 with a AI:Si mass ratio of 30:70. The AISi mono-crystalline substrate 7 is bonded with a layer of 10 µm thick GaN mono-crystalline line layer 2 by Au-Au bonds, wherein the bonding layer 3 is 4 µm in thickness. A layer of graphical structures of reflective layer 4'is embedded in the GaN layer 2 and is at a 4 µm distance from the bonding layer, the graphical structures of reflective layer 4 are cylindrical SiO₂ structures spaced at a 3 µm period, with a base diameter of about 2 µm and a height about 1 µm.

## Claims

1. A method for preparing a composite substrate for GaN growth, comprises the following steps:
1a) growing a GaN mono-crystalline epitaxial layer (2) on a sapphire substrate (5) by:
first growing a layer of GaN (2), then growing a layer of reflective layer materials (4), wherein, the refractive index of the said reflective layer materials (4) is different from that of GaN, the melting point of which is greater than 1000°C, patterning the layer of reflective layer materials (4) with lithography and dry etched well-known in the art into micron-scale or nano-scale periodic structures (4'), and the GaN surface (2) is exposed between the space of these structures, and then growing GaN mono-crystalline (2) continuously to the required thickness;
1b) bonding the GaN epitaxial sheet (2) grown on the sapphire substrate (5) onto a temporary substrate with an epoxy-type instant adhesive, then lifting off the sapphire substrate (5) by laser lift-off method;
1c) bonding the GaN epitaxial sheet (2) on the temporary substrate with a thermally and electrically conductive substrate (1) with a melting point greater than 1000°C, the epoxy-type instant adhesive is carbonized at high temperature, shedding the temporary substrate, obtaining the composite substrate in which the GaN epitaxial sheet (2) of face-up gallium polarity is bonded to the thermally and electrically conductive substrate (1).

2. The method of claim 1, is characterized that, growing GaN mono-crystalline epitaxial layer (2) on the sapphire substrate (5) in the step 1a), transferring GaN mono-crystalline epitaxial layer (2) from the sapphire substrate (5) onto the temporary substrate in the step 1b), and then depositing a metal reflective layer on the surface of GaN mono-crystalline (2), then conducting the step 1c).

3. The method of claim 1, is characterized that, the said reflective layer material (4) is SiO₂ or SiN.

4. The method of claim 1, is characterized that, the said sapphire substrate (5) in the step 1a) is patterned sapphire substrate (5), the patterned sapphire substrate (5) is designed according to the structure of the reflective layer (4) in the composite substrate, obtained by preparing micron-scale or nano-scale periodic structural patterns (4') on the surface of the sapphire substrate (5) by lithography lift-off.

5. The method of claim 1, is characterized that, the bonding method in the step 1c) is rigid bonding or flexible medium bonding, wherein, the rigid bonding is that, Van der Waals bonding the GaN epitaxial sheet (2) on the temporary substrate with a thermally and electrically conductive substrate (1) directly, at 500∼900°C, under a pressure of 3 tons per square inch to 10 tons per square inch, with the coefficient of thermal expansion difference between the materials of the thermally and electrically conductive layer (1) and GaN is within 10% during the rigid bonding; the flexible medium bonding is that, first depositing bonding metals on the surface to be bonded, and then bonding the GaN epitaxial sheet (2) on the temporary substrate with a thermally and electrically conductive substrate (1), at 200∼900°C, under a pressure of 1 tons per square inch to 5 tons per square inch.

6. A method for preparing a composite substrate for GaN growth, comprises the following steps:
2a) growing a GaN mono-crystalline epitaxial layer (2) on a sapphire substrate (5) by:
first growing a layer of GaN (2), then growing a layer of reflective layer materials (4), wherein, the refractive index of the said reflective layer material (4) is different from that of GaN, the melting point of which is greater than 1000°C, patterning the layer of reflective layer material (4) with lithography and dry etched well-known in the art into micron-scale or nano-scale periodic structures (4'), and the GaN surface (2) is exposed between the space of these structures, and then growing GaN mono-crystalline (2) continuously to the required thickness;
2b) bonding the epitaxial sheet grown on the sapphire substrate (5) with a thermally and electrically conductive layer (1) with a melting point greater than 1000°C;
2c) lifting off the sapphire substrate (5) by laser lift-off method, obtaining a composite substrate of face-up nitrogen polarity with the GaN epitaxial sheet (2) bonded with the thermally and electrically conductive layer (1).

7. The method of claim 6, is characterized that, after growing GaN mono-crystalline epitaxial layer (2) on the sapphire substrate (5) in the step 2a), depositing a metal reflective layer on the surface of the GaN mono-crystalline (2), and then conducting the step 2b).

8. The method of claim 6, is characterized that, the said reflective layer material (4) is SiO₂ or SiN.

9. The method of claim 6, is characterized that, the bonding method in the step 2b) is rigid bonding or flexible medium bonding, wherein, the rigid bonding is that, Van der Waals bonding the GaN epitaxial sheet (2) on the sapphire substrate (5) with a thermally and electrically conductive substrate (1) directly, at 500∼900°C, under a pressure of 3 tons per square inch to 10 tons per square inch, with the coefficient of thermal expansion difference between the materials of the thermally and electrically conductive layer (1) and GaN is within 10% during the rigid bonding;
the flexible medium bonding is that, first depositing bonding metals on the surface to be bonded, and then bonding the GaN epitaxial sheet (2) on the sapphire substrate (5) with a thermally and electrically conductive substrate (1), at 200∼900°C, under a pressure of 1 tons per square inch to 5 tons per square inch.

10. The method of any one of the claims 1 - 9, is characterized that, the materials for the thermally and electrically conductive layer (1) choose from one or more of W, Ni, Mo, Pd, Au, Cr, or alloys of one or more above metals with Cu, or Si crystalline, SiC crystalline or AISi crystalline and so on.

## Patentansprüche

1. Verfahren zum Herstellen eines zusammengesetzten Substrats zur GaN-Züchtung, die folgenden Schritte umfassend:
1a) Aufziehen einer monokristallinen Epitaxialschicht (2) aus GaN auf einem Saphirsubstrat (5) durch:
zunächst Aufziehen einer Schicht aus GaN (2), dann Aufziehen einer Schicht aus Reflexionsschichtmaterialien (4), wobei sich der Brechungsindex der Reflexionsschichtmaterialien (4) von demjenigen von GaN unterscheidet, deren Schmelzpunkt über 1000° C liegt, Strukturieren der Schicht aus Reflexionsschichtmaterialien (4) mit Lithografie, und auf dem Gebiet hinlänglich bekanntes Trockenätzen zu periodischen Strukturen (4') im Mikromaßstab oder Nanomaßstab, und die GaN-Oberfläche (2) liegt zwischen dem Raum dieser Strukturen frei, und dann durchgehendes monokristallines (2) Aufziehen von GaN bis zur erforderlichen Dicke;
1b) Aufkleben der auf dem Saphirsubstrat (5) aufgezogenen GaN-Epitaxialschicht (2) auf ein temporäres Substrat mit einem Epoxid-Sofortkleber, dann Abheben des Saphirsubstrats (5) durch ein Laserabhebeverfahren;
1c) Verbinden der GaN-Epitaxialschicht (2) auf dem temporären Substrat mit einem thermisch und elektrisch leitfähigen Substrat (1) mit einem Schmelzpunkt von über 1000° C, wobei der Epoxid-Sofortkleber bei hoher Temperatur verkohlt, Ablösen des temporären Substrats, Gewinnen des zusammengesetzten Substrats, in dem die GaN-Epitaxialschicht (2) mit nach oben gewandter Galliumpolarität an das thermisch und elektrisch leitfähige Substrat (1) geklebt ist.

2. Verfahren nach Anspruch 1, **dadurch gekennzeichnet, dass** das Aufziehen der monokristallinen Epitaxialschicht (2) aus GaN auf dem Saphirsubstrat (5) im Schritt 1a) die monokristalline Epitaxialschicht (2) aus GaN vom Saphirsubstrat (5) auf das temporäre Substrat im Schritt 1b) übertragen und dann eine Metallreflexionsschicht auf der Oberfläche der monokristallinen Epitaxialschicht (2) aus GaN abgeschieden wird, dann der Schritt 1c) durchgeführt wird.

3. Verfahren nach Anspruch 1, **dadurch gekennzeichnet, dass** es sich bei dem Reflexionsschichtmaterial (4) um SiO₂ oder SiN handelt.

4. Verfahren nach Anspruch 1, **dadurch gekennzeichnet, dass** es sich bei dem Saphirsubstrat (5) im Schritt 1a) um ein strukturiertes Saphirsubstrat (5) handelt, das strukturierte Saphirsubstrat (5) entsprechend der Struktur der Reflexionsschicht (4) in dem zusammengesetzten Substrat gestaltet ist, die erhalten wird, indem periodische Strukturenmuster (4') im Mikromaßstab oder Nanomaßstab auf der Oberfläche des Saphirsubstrats (5) durch Lithographieabheben hergestellt werden.

5. Verfahren nach Anspruch 1, **dadurch gekennzeichnet, dass** es sich bei dem Verbindungsverfahren im Schritt 1c) um ein starres Verbinden oder ein Verbinden mit einem flexiblen Medium handelt, wobei das starre Verbinden dergestalt ist, dass die GaN-Epitaxialschicht (2) direkt mittels Van der Waals-Binden auf das temporäre Substrat mit einem thermisch und elektrisch leitfähigen Substrat (1) bei 500 ∼ 900° C unter einem Druck von 3 Tonnen pro Quadratzoll bis 10 Tonnen pro Quadratzoll aufgebracht wird, wobei der thermische Ausdehnungsdifferenzquotient zwischen den Materialien der thermisch und elektrisch leitfähigen Schicht (1) und GaN innerhalb von 10 % während des starren Verbindens liegt; das Verbinden mit einem flexiblen Medium dergestalt ist, dass zunächst Bindemetalle auf der zu verbindenden Oberfläche abgeschieden werden, und dann die GaN-Epitaxialschicht (2) auf das temporäre Substrat (1) mit einem thermisch und elektrisch leitfähigen Substrat (1) bei 200 ∼ 900° C unter einem Druck von 1 Tonne pro Quadratzoll bis 5 Tonnen pro Quadratzoll aufgeklebt wird.

6. Verfahren zum Herstellen eines zusammengesetzten Substrats zur GaN-Züchtung, die folgenden Schritte umfassend:
2a) Aufziehen einer monokristallinen Epitaxialschicht (2) aus GaN auf einem Saphirsubstrat (5) durch:
zunächst Aufziehen einer Schicht aus GaN (2), dann Aufziehen einer Schicht aus Reflexionsschichtmaterialien (4), wobei sich der Brechungsindex der Reflexionsschichtmaterialien (4) von demjenigen von GaN unterscheidet, deren Schmelzpunkt über 1000° C liegt, Strukturieren der Schicht aus Reflexionsschichtmaterial (4) mit Lithografie, und auf dem Gebiet hinlänglich bekanntes Trockenätzen zu periodischen Strukturen (4') im Mikromaßstab oder Nanomaßstab, und die GaN-Oberfläche (2) liegt zwischen dem Raum dieser Strukturen frei, und dann durchgehendes monokristallines (2) Aufziehen von GaN bis zur erforderlichen Dicke;
2b) Verbinden der auf dem Saphirsubstrat (5) aufgezogenen Epitaxialschicht mit einer thermisch und elektrisch leitfähigen Schicht (1) mit einem Schmelzpunkt von über 1000°;
2c) Abheben des Saphirsubstrats (5) durch ein Laser-Abhebeverfahren, Gewinnen eines zusammengesetzten Substrats mit einer nach oben gewandten Stickstoffpolarität, wobei die GaN-Epitaxialschicht (2) mit der thermisch und elektrisch leitfähigen Schicht (1) verbunden ist.

7. Verfahren nach Anspruch 6, **dadurch gekennzeichnet, dass** nach dem Aufziehen der monokristallinen Epitaxialschicht (2) aus GaN auf dem Saphirsubstrat (5) im Schritt 2a) eine Metallreflexionsschicht auf der Oberfläche der monokristallinen Epitaxialschicht (2) aus GaN abgeschieden und dann der Schritt 2b) durchgeführt wird.

8. Verfahren nach Anspruch 6, **dadurch gekennzeichnet, dass** es sich bei dem Reflexionsschichtmaterial (4) um SiO₂ oder SiN handelt.

9. Verfahren nach Anspruch 6, **dadurch gekennzeichnet, dass** es sich bei dem Verbindungsverfahren im Schritt 2b) um ein starres Verbinden oder ein Verbinden mit einem flexiblen Medium handelt, wobei das starre Verbinden dergestalt ist, dass die GaN-Epitaxialschicht (2) direkt mittels Van der Waals-Binden auf das Saphirsubstrat (5) mit einem thermisch und elektrisch leitfähigen Substrat (1) bei 500 ∼ 900° C unter einem Druck von 3 Tonnen pro Quadratzoll bis 10 Tonnen pro Quadratzoll aufgebracht wird, wobei der thermische Ausdehnungsdifferenzquotient zwischen den Materialien der thermisch und elektrisch leitfähigen Schicht (1) und GaN innerhalb von 10 % während des starren Verbindens liegt;
das Verbinden mit einem flexiblen Medium dergestalt ist, dass zunächst Bindemetalle auf der zu verbindenden Oberfläche abgeschieden werden, und dann die GaN-Epitaxialschicht (2) auf das Saphirsubstrat (5) mit einem thermisch und elektrisch leitfähigen Substrat (1) bei 200 ∼ 900° C unter einem Druck von 1 Tonne pro Quadratzoll bis 5 Tonnen pro Quadratzoll aufgeklebt wird.

10. Verfahren nach einem der Ansprüche 1 bis 9, **dadurch gekennzeichnet, dass** die Materialien für die thermisch und elektrisch leitfähige Schicht (1) aus einem oder mehreren Metall/en W, Ni, Mo, Pd, Au, Cr oder Legierungen aus einem oder mehreren der vorstehenden Metalle mt Cu oder kristallinem Si, kristallinem SiC oder kristallinem AISi usw. ausgewählt sind.

## Revendications

1. Procédé de préparation d'un substrat composite pour la croissance de GaN, comprenant les étapes suivantes :
1a) croissance d'une couche épitaxiale monocristalline de GaN (2) sur un substrat de saphir (5) par :
d'abord croissance d'une couche de GaN (2), ensuite croissance d'une couche de matériaux de couche réfléchissante (4), sachant que l'indice de réfraction desdits matériaux de couche réfléchissante (4) est différent de celui de GaN, dont le point de fusion est supérieur à 1000 °C, réalisation de motifs sur la couche de matériaux de couche réfléchissante (4) par lithographie et gravure par voie sèche dans les règles de l'art en structures périodiques (4') à micro-échelle ou nano-échelle, la surface de GaN (2) étant exposée entre l'espace de ces structures, ensuite croissance continue du GaN microcristallin (2) jusqu'à l'épaisseur requise ;
1b) liaison de la feuille épitaxiale de GaN (2) qui a crû sur le substrat de saphir (5) sur un substrat temporaire avec un adhésif instantané de type époxy, ensuite décollage du substrat de saphir (5) par procédé de décollage au laser ;
1c) liaison de la feuille épitaxiale de GaN (2) sur le substrat temporaire à un substrat thermiquement et électriquement conducteur (1) avec un point de fusion supérieur à 1000 °C, l'adhésif instantané de type époxy étant carbonisé à haute température, délestage du substrat temporaire, obtention du substrat composite dans lequel la feuille épitaxiale de GaN (2) de polarité de gallium orientée vers le haut est liée au substrat thermiquement et électriquement conducteur (1).

2. Le procédé de la revendication 1, **caractérisé par** la croissance de la couche épitaxiale monocristalline de GaN (2) sur le substrat de saphir (5) à l'étape 1a), transfert de la couche épitaxiale monocristalline de GaN (2) du substrat de saphir (5) au substrat temporaire à l'étape 1b), ensuite dépôt d'une couche réfléchissante de métal sur la surface du GaN monocristallin (2), ensuite l'exécution de l'étape 1c).

3. Le procédé de la revendication 1, **caractérisé en ce que** ledit matériau de couche réfléchissante (4) est SiO₂ ou SiN.

4. Le procédé de la revendication 1, **caractérisé en ce que** ledit substrat de saphir (5) à l'étape 1a) est un substrat de saphir (5) à motifs, le substrat de saphir (5) à motifs étant conçu selon la structure de la couche réfléchissante (4) dans le substrat composite, obtenu par préparation de motifs structurels périodiques (4') à micro-échelle ou nano-échelle sur la surface de saphir (5) par décollage par lithographie.

5. Le procédé de la revendication 1, **caractérisé en ce que** le procédé de liaison à l'étape 1c) est une liaison rigide ou une liaison par support flexible, sachant que la liaison rigide correspond à la liaison Van der Waals de la feuille épitaxiale de GaN (2) sur le substrat temporaire avec un substrat thermiquement et électriquement conducteur (1) directement, à 500 ∼ 900 °C, sous une pression de 3 tonnes par pouce carré à 10 tonnes par pouce carré, le coefficient de différence de dilatation thermique entre les matériaux de la couche thermiquement et électriquement conductrice (1) et GaN étant compris dans une plage de 10 % pendant la liaison rigide ;
la liaison par support flexible correspond d'abord au dépôt de métaux de liaison sur la surface à lier, ensuite liaison de la feuille épitaxiale de GaN (2) sur le substrat temporaire avec un substrat thermiquement et électriquement conducteur (1), à 200 ∼ 900 °C, sous une pression de 1 tonne par pouce carré à 5 tonnes par pouce carré.

6. Procédé de préparation d'un substrat composite pour la croissance de GaN, comprenant les étapes suivantes :
2a) croissance d'une couche épitaxiale monocristalline de GaN (2) sur un substrat de saphir (5) par :
d'abord croissance d'une couche de GaN (2), ensuite croissance d'une couche de matériaux de couche réfléchissante (4), sachant que l'indice de réfraction desdits matériaux de couche réfléchissante (4) est différent de celui de GaN, dont le point de fusion est supérieur à 1000 °C, réalisation de motifs sur la couche de matériaux de couche réfléchissante (4) par lithographie et gravure par voie sèche dans les règles de l'art en structures périodiques (4') à micro-échelle ou nano-échelle, la surface de GaN (2) étant exposée entre l'espace de ces structures, ensuite croissance continue du GaN microcristallin (2) jusqu'à l'épaisseur requise ;
2b) liaison de la feuille épitaxiale qui a crû sur le substrat de saphir (5) à une couche thermiquement et électriquement conductrice (1) avec un point de fusion supérieur à 1000 °C ;
2c) décollage du substrat de saphir (5) par procédé de décollage au laser, obtention d'un substrat composite de polarité d'azote orientée vers le haut avec la feuille épitaxiale de GaN (2) liée à la couche thermiquement et électriquement conductrice (1).

7. Le procédé de la revendication 6, **caractérisé par**, après la croissance de la couche épitaxiale monocristalline de GaN (2) sur le substrat de saphir (5) à l'étape 2a), le dépôt d'une couche réfléchissante de métal sur la surface du GaN monocristallin (2), ensuite exécution de l'étape 2b).

8. Le procédé de la revendication 6, **caractérisé en ce que** ledit matériau de couche réfléchissante (4) est SiO₂ ou SiN.

9. Le procédé de la revendication 6, **caractérisé en ce que** le procédé de liaison à l'étape 2b) est une liaison rigide ou une liaison par support flexible, sachant que la liaison rigide correspond à la liaison Van der Waals de la feuille épitaxiale de GaN (2) sur le substrat de saphir (5) avec un substrat thermiquement et électriquement conducteur (1) directement, à 500 ∼ 900 °C, sous une pression de 3 tonnes par pouce carré à 10 tonnes par pouce carré, le coefficient de différence de dilatation thermique entre les matériaux de la couche thermiquement et électriquement conductrice (1) et GaN étant compris une plage de 10 % pendant la liaison rigide ;
la liaison par support flexible correspond d'abord au dépôt de métaux de liaison sur la surface à lier, ensuite liaison de la feuille épitaxiale de GaN (2) sur le substrat de saphir (5) avec un substrat thermiquement et électriquement conducteur (1), à 200∼900 °C, sous une pression de 1 tonne par pouce carré à 5 tonnes par pouce carré.

10. Le procédé de l'une quelconque des revendications 1 à 9, **caractérisé en ce que** les matériaux pour la couche thermiquement et électriquement conductrice (1) sont sélectionnés parmi un ou plusieurs de W, Ni, Mo, Pd, Au, Cr, ou des alliages d'un ou plusieurs des métaux ci-dessus avec Cu, ou Si cristallin, SiC cristallin ou AISi cristallin et ainsi de suite.
